# EUROPEAN PATENT SPECIFICATION

(11) **EP 3 460 932 B1**
(45) Date of publication and mention of the grant of the patent: **04.11.2020**
(21) Application number: 16902431.2
(22) Date of filing: 20.05.2016
(51) Int. Cl.: H01H 33/00, H02H 3/04, G01R 31/327, H02H 3/05, H02H 3/00, H02H 1/06, H02H 3/093

(54) **CIRCUIT BREAKER**
SCHUTZSCHALTER
DISJONCTEUR

(43) Date of publication of application: 27.03.2019
(73) Proprietor: Mitsubishi Electric Corporation, Chiyoda-ku Tokyo 100-8310 (JP)
(72) Inventor: MATSUDA Kazuhisa, Tokyo 102-0073 (JP); HAYASHI Akihiro, Tokyo 102-0073 (JP)
(74) Representative: Diehl & Partner
(86) International application number: PCT/JP2016/064972
(87) International publication number: WO 2017/199412

(56) References cited:
- JP-A- H03 291 817
- JP-A- H09 161 626
- JP-A- H11 299 083
- JP-A- 2014 124 057
- JP-A- 2014 124 057
- TW-A- 201 011 306
- US-A- 5 170 309

## Description

### Technical Field

The present invention relates to a circuit breaker connected to an alternating current circuit, and in particular, relates to a circuit breaker incorporating an overcurrent tripping device that operates using a microcomputer.

### Background Art

An overcurrent tripping device incorporated in this kind of circuit breaker is such that an overcurrent is computed by a microcomputer, and tripping is carried out as necessary.

Current flowing into each phase of a circuit breaker is transformed by a current transformer and full-wave rectified in each phase by a rectifier, the currents after rectification are converted in peak conversion and effective value conversion circuits, and the like, the phase in which the current is largest is selected, and when an overcurrent or a large current flows, each time limit circuit operates in accordance with a value of the current, and a trigger circuit outputs a trigger signal, thereby exciting a tripping coil, and causing a switching mechanism to operate.

For example, a circuit breaker shown in Patent Document 1 is configured so that current flowing through a circuit is detected by current detecting means, and a microcomputer causes a tripping signal to be generated in accordance with a value of the detected current.

In particular, the circuit breaker of Patent Document 1 is such that the microcomputer becoming unstable when a power supply voltage supplied to the microcomputer is low is taken up as a technical problem, and it is proposed that when the power supply voltage reaches a predetermined value or more, the microcomputer is caused to operate correctly by being reset and restarted.

### Citation List

### Patent Literature

Patent Document 1: JP A 6 245362
JP H09-161626, JP 2014-124057 and TW 201011306 each disclose features of the preamble of independent claim 1. JP 2014-124057 and TW 201011306 further teach to use a microcomputer in combination with current detecting coils to control a trip coil.
A four-pole circuit breaker is disclosed by US 5,170,309. The circuit breaker comprises a current sensor using air-core coils for detecting a load current and a current transformer, a rectifier circuit and a power source circuit to drive the circuit breaker using power derived from the load current.

### Summary of Invention

### Technical Problem

When a load current is detected and a current value is computed by a microcomputer, as in Patent Document 1, there is a problem in that there is a possibility that current detection cannot be correctly carried out, and tripping is erroneously carried out, when the microcomputer that carries out overcurrent detection itself falls into a runaway state due to disturbance noise or the like, and conversely, there is a possibility of the microcomputer falling into a state of not carrying out tripping when necessary.

The invention, having been contrived in order to resolve the previously described kind of problem, has an object of detecting an abnormal state of a microcomputer, and detecting a runaway state when the microcomputer falls into such a state, thereby avoiding an erroneous tripping or an inability to trip caused by a malfunction of the microcomputer.

The invention has an object of avoiding an erroneous tripping or an inability to trip caused by a malfunction of the microcomputer by duplicating current detection.

### Solution to Problem

The above object is solved by the combination of features of independent claim 1. Preferred embodiments are defined in the dependent claims.

A circuit breaker according to the invention includes a first current detecting circuit that detects a load current using a microcomputer in accordance with a signal output from a current detecting coil, a second current detecting circuit that detects a load current using an output current of a power supply CT, and comparison means that compares an output signal of the first current detecting circuit and an output signal of the second current detecting circuit, and determines whether an operation of the microcomputer is normal or abnormal.

### Advantageous Effects of Invention

The invention is such that rather than current detection being carried out only by a current sensor and a microcomputer, a function of detecting a load current using a power supply CT is added, whereby a runaway state of the microcomputer is detected, and an erroneous tripping or an inability to trip caused by an abnormal alarm output of a microcomputer or disturbance noise can be prevented.

### Brief Description of Drawings

[Fig. 1] Fig. 1 is a circuit diagram of an overcurrent tripping device in a first embodiment of the invention, having a duplicated function of detecting current.
[Fig. 2] Fig. 2 is an external appearance view showing a trigger relay unit of an air circuit breaker in the first embodiment of the invention.
[Fig. 3] Fig. 3 is an equivalent circuit diagram of a dial setting output in the first embodiment of the invention.
[Fig. 4] Fig. 4 is a connection diagram of a reference voltage converting circuit in the first embodiment of the invention.
[Fig. 5] Fig. 5 is a characteristic diagram showing characteristics of dial setting values and reference voltage values in the first embodiment of the invention.
[Fig. 6] Fig. 6 is a characteristic diagram showing characteristics of dial setting values and reference voltage values when provided with power supply CT saturation characteristics in the first embodiment of the invention.
[Fig. 7] Fig. 7 is an overall connection diagram of an equivalent circuit of the reference voltage converting circuit and dial setting outputs in the first embodiment of the invention.
[Fig. 8] Fig. 8 is an internal circuit diagram when a microcomputer resetting function is added to a tripping device having a duplicated function of detecting current in a second embodiment of the invention.
[Fig. 9] Fig. 9 is an internal circuit diagram when having a duplicated function of detecting an overcurrent in a third embodiment of the invention.

### Description of Embodiments

### First Embodiment

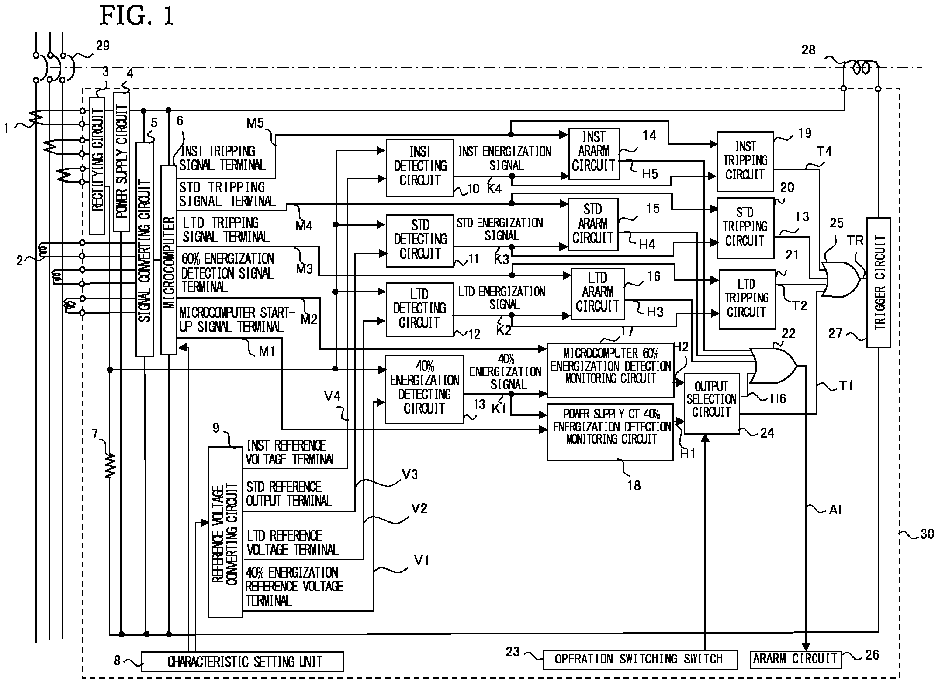

Fig. 1 is a circuit diagram of an overcurrent tripping device in a first embodiment of the invention, having a duplicated function of detecting current. A secondary side output of a power supply CT 1 is connected to a power supply circuit 4 and a current detecting resistor 7 via a rectifying circuit 3.

A constant voltage generated by the power supply circuit 4 is supplied as a drive power supply of a signal converting circuit 5 for transmitting information on a load current detected in a current detecting coil 2 (Rogowski coil), which is a current sensor, to a microcomputer 6, and a drive power supply of a tripping coil 28 having a function of opening a circuit breaker contact 29 that switches a load current flowing into a circuit, and causing a circuit breaker main body (not shown) to be turned off.

The microcomputer 6 receives a current signal from the signal converting circuit 5, and carries out an evaluation of an energizing current of the circuit breaker main body. The microcomputer 6 includes terminals that output a microcomputer drive signal M1, a 60 % energization detection signal M2, an LTD tripping signal M3, an STD tripping signal M4, and an INST tripping signal M5, the signal M1 of the microcomputer drive signal terminal changes to a high state when the signals M1 to M5 of the terminals of the microcomputer 6 are in a low state but the energizing current reaches a current that can drive the microcomputer 6, and when it is determined that the energizing current has reached 60 % of a circuit breaker rated current, the 60 % energization detection signal M2 changes to a high state.

Also, when the energizing current of the circuit breaker main body exceeds the rated current and reaches an overcurrent state, the LTD tripping signal M3 to the INST tripping signal M5 for causing the circuit breaker to be turned off are output in accordance with an operating time set by a characteristic setting unit 8, but the operating time is divided into three regions, those being LTD (long time delay tripping), STD (short time delay tripping), and INST (instantaneous tripping), in accordance with a magnitude of the energizing current. Thresholds of detected currents of the long time delay LTD, the short time delay STD, and the instantaneous INST regions have a relationship such that long time delay LTD < short time delay STD < instantaneous INST, and the detection thresholds can be changed by the characteristic setting unit 8.

Also, times until the long time delay LTD tripping signal M3 to the instantaneous INST tripping signal M5 are output from the microcomputer 6 after the detection threshold is exceeded are such that the long time delay LTD is the longest, a relationship is that long time delay LTD > short time delay STD > instantaneous INST, and the operating time can be changed by the characteristic setting unit 8.

A reference voltage converting circuit 9 generates reference voltages determining whether a current value detected by the current detecting resistor 7 has exceeded 40 % of the rated current of the circuit breaker main body, and whether a current in the long time delay LTD region, a current in the short time delay STD region, or a current in the instantaneous INST region is flowing, and thresholds can be changed by the characteristic setting unit 8, in the same way as the detected current thresholds of the microcomputer 6.

A 40 % energization signal K1, which is an output signal of a 40 % energization detecting circuit 13, is in a low state when energization is started, and changes to a high state when a detected voltage of the current detecting resistor 7 exceeds a voltage V1 of a 40 % energization reference voltage terminal of the reference voltage converting circuit 9.

In the same way, a long time delay LTD energization signal K2, which is an output signal of a long time delay LTD detecting circuit 12, changes to a high state when a detected voltage of the current detecting resistor 7 exceeds a voltage V2 of a long time delay LTD reference voltage terminal of the reference voltage converting circuit 9.

Also, a short time delay STD energization signal K3, which is an output signal of a short time delay STD detecting circuit 11, changes to a high state when a detected voltage of the current detecting resistor 7 exceeds a voltage V3 of a short time delay STD reference voltage terminal of the reference voltage converting circuit 9.

Also, an instantaneous INST energization signal K4, which is an output signal of an instantaneous INST detecting circuit 10, changes to a high state when a detected voltage of the current detecting resistor 7 exceeds a voltage V4 of an instantaneous INST reference voltage terminal of the reference voltage converting circuit 9.

A power supply CT 40 % energization detection monitoring circuit 18 outputs an output signal H1 in a high state when the 40 % energization signal K1, which is the output signal of the 40 % energization detecting circuit 13, is in the high state and the microcomputer drive signal M1 is in a low state, and outputs the output signal H1 in a low state in other cases.

A microcomputer 60 % energization detecting circuit 17 outputs an output signal H2 in a high state when the 60 % energization detecting signal M2 is in the high state and the 40 % energization signal K1, which is the output signal of the 40 % energization detecting circuit 13, is in the low state, and outputs the output signal H2 in a low state in other cases.

A long time delay LTD alarm circuit 16 outputs an output signal H3 in a high state when the long time delay LTD tripping signal M3 is in the high state and the long time delay LTD energization signal K2, which is the output signal of the long time delay LTD detecting circuit 12, is in the low state, and outputs the output signal H3 in a low state in other cases.

A short time delay STD alarm circuit 15 outputs an output signal H4 in a high state when the short time delay STD tripping signal M4 is in the high state and the short time delay STD energization signal K3, which is the output signal of the short time delay STD detecting circuit 11, is in the low state, and outputs the output signal H4 in a low state in other cases.

An instantaneous INST alarm circuit 14 outputs an output signal H5 in a high state when the instantaneous INST tripping signal M5 is in the high state and the instantaneous INST energization signal K4, which is the output signal of the instantaneous INST detecting circuit 10, is in the low state, and outputs the output signal H5 in a low state in other cases.

An INST tripping circuit 19 outputs an output signal T4 in a high state when the instantaneous INST tripping signal M5 and the instantaneous INST energization signal K4 are both in the high state, and outputs the output signal T4 in a low state in other cases.

A short time delay STD tripping circuit 20 outputs an output signal T3 in a high state when the short time delay STD tripping signal M4 and the short time delay STD energization signal K3 are both in the high state, and outputs the output signal T3 in a low state in other cases.

A long time delay LTD tripping circuit 21 outputs an output signal T2 in a high state when the long time delay LTD tripping signal M3 and the long time delay LTD energization signal K2 are both in the high state, and outputs the output signal T2 in a low state in other cases.

A first OR circuit 25 outputs an output signal TR in a high state when any one of input signals T1, T2, T3, and T4 changes to a high state, and outputs the output signal TR in a low state in other cases.

A trigger circuit 27 causes an exciting current to flow into the tripping coil 28 when the output signal TR of the first OR circuit 25 changes to the high state, thereby turning off the circuit breaker main body, but does not cause an exciting current to flow into the tripping coil 28 when the output signal TR is in the low state.

When either the output signal H1 of the power supply CT 40 % energization detection monitoring circuit 18 or the output signal H2 of the microcomputer 60 % energization detecting circuit 17 changes to the high state, an output selection circuit 24 outputs an output signal H6 in a high state when an operation switching switch 23 is set to an alarm side, outputs the output signal T1 of the output selection circuit 24 in a high state when the operation switching switch 23 is set to a tripping side, and outputs the output signal T1 in a low state in other cases.

A second OR circuit 22 outputs an output signal AL in a high state when any one of the input signals H3, H4, H5, and H6 changes to a high state, and outputs the output signal AL in a low state in other cases.

An alarm circuit 26 outputs an alarm when the output signal AL of the OR circuit 22 changes to a high state, but does not output an alarm when the signal AL is in the low state.

When a relationship between the detected current thresholds for outputting the output signals M1 to M5 from the microcomputer 6 and the detected current thresholds of the output signals K1 to K4 emitted based on the detected voltage of the current detecting resistor 7 is M1 < K1 < M2 < K2 < M3 < K3 < M4 < K4 < M5, a state of each signal depending on differences in the energization state of the circuit breaker main body is as in Table 1 and Table 2.

### [Table 1]

**Table 1**

| | | When Normal | | | | | |
|---|---|---|---|---|---|---|---|
| Main Body Energization State | | 10 % | 40 % | 60 % | LTD Current | STD Current | INST Current |
| Microcomputer | M5 | L | L | L | L | L | H |
| Power supply CT detecting circuit | K4 | L | L | L | L | L | H |
| Microcomputer | M4 | L | L | L | L | H | H |
| Power supply CT detecting circuit | K3 | L | L | L | L | H | H |
| Microcomputer | M3 | L | L | L | H | H | H |
| Power supply CT detecting circuit | K2 | L | L | L | H | H | H |
| Microcomputer | M2 | L | L | H | H | H | H |
| Power supply CT detecting circuit | K1 | L | H | H | H | H | H |
| Microcomputer | M1 | H | H | H | H | H | H |
| INST alarm circuit | H5 | L | L | L | L | L | L |
| STD alarm circuit | H4 | L | L | L | L | L | L |
| LTD alarm circuit | H3 | L | L | L | L | L | L |
| 60 % energization monitoring circuit | H2 | L | L | L | L | L | L |
| 40 % energization monitoring circuit | H1 | L | L | L | L | L | L |
| INS tripping circuit | T4 | L | L | L | L | L | H |
| STD tripping circuit | T3 | L | L | L | L | H | H |
| LTD tripping circuit | T2 | L | L | L | H | H | H |
| Output selection circuit Tripping side selection | T1 | L | L | L | L | L | L |
| | H6 | | | | | | |
| Alarm circuit | AL | L | L | L | L | L | L |
| Tripping circuit | TR | L | L | L | H | H | H |

### [Table 2]

**Table 2**

| | | When Normal | | | | | |
|---|---|---|---|---|---|---|---|
| Main Body Energization State | | 10 % | 40 % | 60 % | LTD Current | STD Current | INST Current |
| Microcomputer | M5 | L | L | L | L | L | H |
| Power supply CT detecting circuit | K4 | L | L | L | L | L | H |
| Microcomputer | M4 | L | L | L | L | H | H |
| Power supply CT detecting circuit | K3 | L | L | L | L | H | H |
| Microcomputer | M3 | L | L | L | H | H | H |
| Power supply CT detecting circuit | K2 | L | L | L | H | H | H |
| Microcomputer | M2 | L | L | H | H | H | H |
| Power supply CT detecting circuit | K1 | L | H | H | H | H | H |
| Microcomputer | M1 | H | H | H | H | H | H |
| INST alarm circuit | H5 | L | L | L | L | L | L |
| STD alarm circuit | H4 | L | L | L | L | L | L |
| LTD alarm circuit | H3 | L | L | L | L | L | L |
| 60 % energization monitoring circuit | H2 | L | L | L | L | L | L |
| 40 % energization monitoring circuit | H1 | L | L | L | L | L | L |
| INS tripping circuit | T4 | L | L | L | L | L | H |
| STD tripping circuit | T3 | L | L | L | L | H | H |
| LTD tripping circuit | T2 | L | L | L | H | H | H |
| Output selection circuit Tripping side selection | T1 | | | | | | |
| | H6 | L | L | L | L | L | L |
| Alarm circuit | AL | L | L | L | L | L | L |
| Tripping circuit | TR | L | L | L | H | H | H |

Table 1 is a table showing a state of each signal depending on differences in the energization state of the circuit breaker main body when the operation switching switch 23 in the first embodiment of the invention is set to the tripping side, and the overcurrent tripping device is normal.

Table 2 is a table showing a state of each signal depending on differences in the energization state of the circuit breaker main body when the operation switching switch 23 in the first embodiment of the invention is set to the alarm side, and the overcurrent tripping device is normal. Assuming that the microcomputer starts up at 10 % of the rated current, the signal M1 changes to the high state when the circuit breaker main body is energized to 10 %, but the signal AL and the signal TR both remain in the low state, and neither an alarm output nor a turning off of the circuit breaker owing to excitation of the tripping coil 28 takes place. In the same way, the signals M1 and K1 change to the high state when the circuit breaker main body is energized to 40 %, but the signal AL and the signal TR both remain in the low state, and neither an alarm output nor a turning off of the circuit breaker owing to excitation of the tripping coil 28 takes place.

The signals M1, K1, and M2 change to the high state when the circuit breaker main body is energized to 60 %, but the signal AL and the signal TR both remain in the low state, and neither an alarm output nor a turning off of the circuit breaker owing to excitation of the tripping coil 28 takes place.

When an overcurrent in the long time delay LTD region flows, the signals M1, K1, M2, K2, and M3 change to the high state, the output signal TR of the first OR circuit 25 changes to the high state, and the circuit breaker is turned off by the tripping coil 28 being excited, but as the signal AL remains in the low state, no alarm output is carried out.

In the same way, when an overcurrent in the short time delay STD region flows, the signals M1, K1, M2, K2, M3, K3, and M4 change to the high state, the signal TR changes to the high state, and the circuit breaker is turned off by the tripping coil 28 being excited, but as the signal AL remains in the low state, no alarm output is carried out. When an overcurrent in the instantaneous INST region flows, the signals M1, K1, M2, K2, M3, K3, M4, K4, and M5 change to the high state, the signal TR changes to the high state, and the circuit breaker is turned off by the tripping coil 28 being excited, but as the signal AL remains in the low state, no alarm output is carried out.

Next, a state of each signal depending on differences in the energization state of the main body when there is an abnormality in the microcomputer 6 or the 40 % energization detecting circuit 13 is shown in Table 3 and Table 4.

### [Table 3]

**Table 3**

| | | When Abnormality Occurs | | | | | | | |
|---|---|---|---|---|---|---|---|---|---|
| Main Body Energization State | | 40 % | 60 % | 60 % | 60 % | 60 % | LTD Current | STD Current | INST Current |
| Microcomputer | M5 | L | L | L | L | H | L | H | H |
| Power supply CT detecting circuit | K4 | L | L | L | L | L | L | L | L |
| Microcomputer | M4 | L | L | L | H | H | H | H | H |
| Power supply CT detecting circuit | K3 | L | L | L | L | L | L | L | H |
| Microcomputer | M3 | L | L | H | H | H | H | H | H |
| Power supply CT detecting circuit | K2 | L | L | L | L | L | H | H | H |
| Microcomputer | M2 | L | H | H | H | H | H | H | H |
| Power supply CT detecting circuit | K1 | H | L | H | H | H | H | H | H |
| Microcomputer | M1 | L | H | H | H | H | H | H | H |
| INST alarm circuit | H5 | L | L | L | L | H | L | H | H |
| STD alarm circuit | H4 | L | L | L | H | H | H | H | L |
| LTD alarm circuit | H3 | L | L | H | H | H | L | L | L |
| 60 % energization monitoring circuit | H2 | L | H | L | L | L | L | L | L |
| 40 % energization monitoring circuit | H1 | H | L | L | L | L | L | L | L |
| INS tripping circuit | T4 | L | L | L | L | L | L | L | L |
| STD tripping circuit | T3 | L | L | L | L | L | L | L | H |
| LTD tripping circuit | T2 | L | L | L | L | L | H | H | H |
| Output selection circuit Tripping side selection | T1 | H | H | L | L | L | L | L | L |
| | H6 | | | | | | | | |
| Alarm circuit | AL | L | L | H | H | H | H | H | H |
| Tripping circuit | TR | H | H | L | L | L | H | H | H |
| | | | | | | | LTD tripping | LTD tripping | STD tripping |

### [Table 4]

**Table 4**

| | | When Abnormality Occurs | | | | | | | |
|---|---|---|---|---|---|---|---|---|---|
| Main Body Energization State | | 40 % | 60 % | 60 % | 60 % | 60 % | LTD Current | STD Current | INST Current |
| Microcomputer | M5 | L | L | L | L | H | L | H | H |
| Power supply CT detecting circuit | K4 | L | L | L | L | L | L | L | L |
| Microcomputer | M4 | L | L | L | H | H | H | H | H |
| Power supply CT detecting circuit | K3 | L | L | L | L | L | L | L | H |
| Microcomputer | M3 | L | L | H | H | H | H | H | H |
| Power supply CT detecting circuit | K2 | L | L | L | L | L | H | H | H |
| Microcomputer | M2 | L | H | H | H | H | H | H | H |
| Power supply CT detecting circuit | K1 | H | L | H | H | H | H | H | H |
| Microcomputer | M1 | L | H | H | H | H | H | H | H |
| INST alarm circuit | H5 | L | L | L | L | H | L | H | H |
| STD alarm circuit | H4 | L | L | L | H | H | H | H | L |
| LTD alarm circuit | H3 | L | L | H | H | H | L | L | L |
| 60 % energization monitoring circuit | H2 | L | H | L | L | L | L | L | L |
| 40 % energization monitoring circuit | H1 | H | L | L | L | L | L | L | L |
| INS tripping circuit | T4 | L | L | L | L | L | L | L | L |
| STD tripping circuit | T3 | L | L | L | L | L | L | L | H |
| LTD tripping circuit | T2 | L | L | L | L | L | H | H | H |
| Output selection circuit Tripping side selection | T1 | | | | | | | | |
| | H6 | H | H | L | L | L | L | L | L |
| Alarm circuit | AL | H | H | H | H | H | H | H | H |
| Tripping circuit | TR | L | L | L | L | L | H | H | H |
| | | | | | | | LTD tripping | LTD tripping | STD tripping |

Table 3 is a table showing a state of each signal depending on differences in the energization state of the circuit breaker 23 main body when the operation switching switch 23 in the first embodiment of the invention is set to the tripping side, and the overcurrent tripping device is abnormal. Also, Table 4 is a table showing a state of each signal depending on differences in the energization state of the circuit breaker main body when the operation switching switch in the first embodiment of the invention is set to the alarm side, and the overcurrent tripping device is abnormal.

When the signal M1 remains in the low state due to an abnormality in the microcomputer 6, despite 40 % energization of the circuit breaker main body, that is, when no start-up signal is output from the microcomputer 6, the signal TR changes to the high state, the circuit breaker main body is turned off, and notification of the abnormality is carried out when the operation switching switch 23 of Table 3 is set to the tripping side. Also, when the operation switching switch 23 of Table 4 is set to the alarm side, the signal AL changes to the high state, and notification of the abnormality is carried out by an alarm being output.

Also, when the signal K1 remains in the low state due to an abnormality in the 40 % energization detecting circuit 13, despite 60 % energization of the circuit breaker main body, the signal TR changes to the high state, the circuit breaker main body is turned off, and notification of the abnormality is carried out when the operation switching switch 23 of Table 3 is set to the tripping side, and when the operation switching switch 23 of Table 4 is set to the alarm side, the signal AL changes to the high state, and notification of the abnormality is carried out by an alarm being output. In addition to this, when the signals M3, M4, and M5 change to the high state due to an abnormality in the microcomputer 6, despite 60 % energization of the circuit breaker main body, the signal AL changes to the high state, and notification of the abnormality is carried out by an alarm being output, both when the operation switching switch 23 of Table 3 is set to the tripping side and when the operation switching switch 23 is set to the alarm side of Table 4.

With regard to an abnormality in an overcurrent region, when the signals M4 and M5 change to the high state due to an abnormality in the microcomputer 6, despite energization in the long time delay LTD region, the signal TR changes to the high state, the signal AR changes to the high state simultaneously with the circuit breaker main body being turned off, and notification of the abnormality is carried out by an alarm being output, both when the operation switching switch 23 of Table 3 is set to the tripping side and when the operation switching switch 23 is set to the alarm side of Table 4.

Also, when the signal M5 changes to the high state due to an abnormality in the microcomputer 6, despite energization in the short time delay STD region, the signal TR changes to the high state, the signal AL changes to the high state simultaneously with the circuit breaker main body being turned off, and notification of the abnormality is carried out by an alarm being output, both when the operation switching switch 23 of Table 3 is set to the tripping side and when the operation switching switch 23 is set to the alarm side of Table 4.

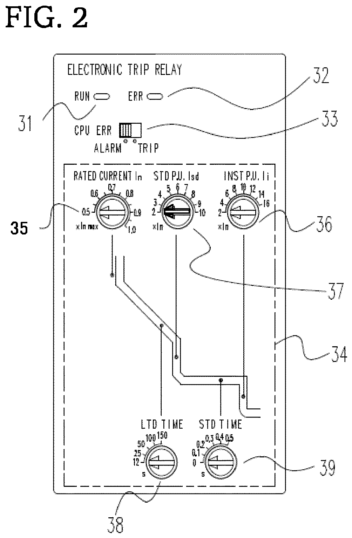

Fig. 2 is an example of an external appearance of the overcurrent tripping device of Fig. 1 incorporating a circuit having a duplicated function of detecting current. A RUN LED 31 is illuminated when energization of the circuit breaker main body is started and the microcomputer 6 starts up. An ERR LED 32 is coordinated with the alarm circuit 26, and notifies of an abnormality by being illuminated when an alarm is output. Also, a switch 33 corresponds to the operation switching switch 23, and selection of whether an alarm is to be output or the circuit breaker main body is to be turned off when a microcomputer abnormality occurs can be carried out from an exterior. Also, a first rotary switch 35, being a switch for setting the rated current from the exterior, is a switch for setting the detected current threshold of the long time delay LTD region. A second rotary switch 37 is a switch for setting the detected current threshold of the short time delay STD region. A third rotary switch 36 is a switch for setting the detected current threshold of the instantaneous INST region. Also, a fourth rotary switch 38 is a switch for setting an operating time when the detected current threshold of the long time delay LTD region is exceeded. A fifth rotary switch 39 is a switch for setting an operating time when the detected current threshold of the short time delay STD region is exceeded.

A setting unit 34 in which the first to fifth rotary switches 35 to 39 are gathered corresponds to the characteristic setting unit 8 of Fig. 1. Dial setting values are decided so that the relationship between detected current thresholds is long time delay LTD < short time delay STD < instantaneous INST, and the relationship between operating times until the circuit breaker is turned off is long time delay LTD > short time delay STD > instantaneous INST. As the circuit breaker is turned off immediately after detection, no setting dial is prepared for an operating time in the instantaneous INST region.

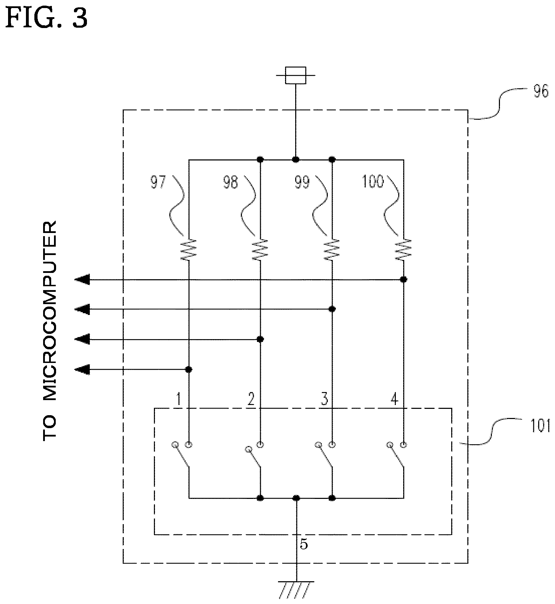

An output pattern of the reference voltage converting circuit 9 in the first embodiment of the invention when the first to fifth rotary switches 35 to 39are of a contact disposition of a switch 101 shown in Fig. 3, is shown in Table 5.

**[Table 5] Table 5**

| Dial Setting Position | 0.5 | 0.55 | 0.6 | 0.65 | 0.7 | 0.75 | 0.8 | 0.85 | 0.9 | 0.95 | 1 |
|---|---|---|---|---|---|---|---|---|---|---|---|
| Terminal 1 | ○ | | ○ | | ○ | | ○ | | ○ | | ○ |
| Terminal 2 | | ○ | ○ | | | ○ | ○ | | | ○ | ○ |
| Terminal 3 | | | | ○ | ○ | ○ | ○ | | | | |
| Terminal 4 | | | | | | | | ○ | ○ | ○ | ○ |

| | | | | | | | | | | | |
|---|---|---|---|---|---|---|---|---|---|---|---|
| ○ indicates continuity with terminal 5 | | | | | | | | | | | |

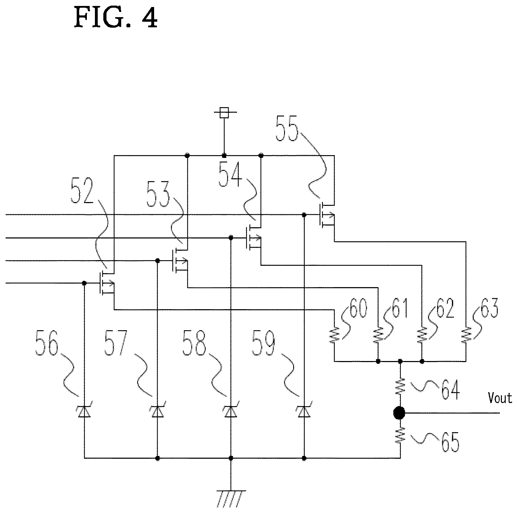

By terminals 1 to 4 of the switch 101 being connected to a signal power supply by resistors 97 to 100, as in Fig. 3, the microcomputer 6 can distinguish a setting position of a rotary switch based on high state and low state information of the four terminals, using a Gray code switch having continuity characteristics of Table 5. Also, by the terminals 1 to 4 of the switch 101 being connected to the kind of reference voltage converting circuit in Fig. 4, FETs 52 to 55 switch between a state of continuity and a state of non-continuity in accordance with the high states and low states of the terminals 1 to 4, and an output voltage Vout is changed in accordance with voltage dividing resistors 60 to 65. Zener diodes 56 to 59 are for protecting the FETs 52 to 55 from gate overvoltage.

Table 6 is a table showing an example of a dial setting output pattern and output voltage of the reference voltage converting circuit 9 in the first embodiment of the invention.

### [Table 6]

**Table 6**

| | In Setting | 0.5 | 0.55 | 0.6 | 0.65 | 0.7 | 0.75 | 0.8 | 0.85 | 0.9 | 0.95 | 1 |
|---|---|---|---|---|---|---|---|---|---|---|---|---|
| Conduction Resistance (kΩ) | 82 | ○ | | ○ | | ○ | | ○ | | ○ | | ○ |
| | 43 | | ○ | ○ | | | ○ | ○ | | | ○ | ○ |
| | 22 | | | | ○ | ○ | ○ | ○ | | | | |
| | 11 | | | | | | | | ○ | ○ | ○ | ○ |
| Combined Resistance (kΩ) | | 82.00 | 43.00 | 28.21 | 22.00 | 17.35 | 14.55 | 12.36 | 11.00 | 9.70 | 8.76 | 7.91 |
| Overall Combined Resistance Ra = 10k, Rb = 7.5k | | 99.50 | 60.50 | 45.71 | 39.50 | 34.85 | 32.05 | 29.86 | 28.50 | 27.20 | 26.26 | 25.41 |
| Vct REF(L)[V] | | 0.21 | 0.36 | 0.51 | 0.61 | 0.72 | 0.80 | 0.89 | 0.95 | 1.02 | 1.07 | 1.13 |

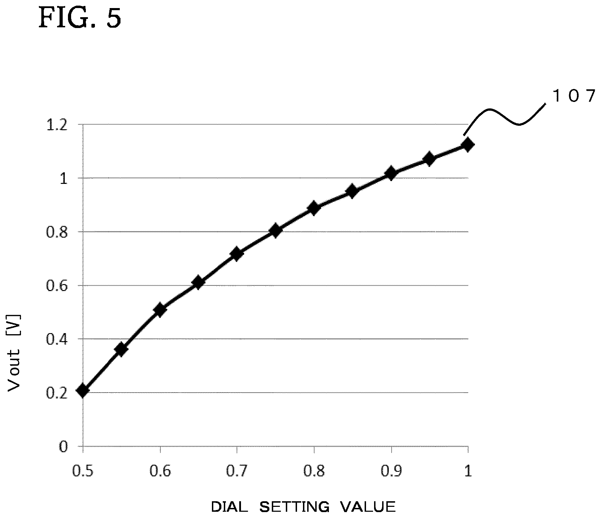

Herein, by values of the voltage dividing resistors 60 to 65 being selected as in Table 6, a value of Vout increases proportionally in accordance with the dial setting, as in a characteristic diagram of a relationship 107 between dial setting value and reference voltage shown in Fig. 5.

Also, Table 7 is a table showing an example of a dial setting output pattern and output voltage of the reference voltage converting circuit in the first embodiment of the invention when provided with power supply CT saturation characteristics.

### [Table 7]

**Table 7**

| | Ir Setting | 0.5 | 0.55 | 0.6 | 0.65 | 0.7 | 0.75 | 0.8 | 0.85 | 0.9 | 0.95 | 1 |
|---|---|---|---|---|---|---|---|---|---|---|---|---|
| Conduction Resistance (kΩ) | 12 | ○ | | ○ | | ○ | | ○ | | ○ | | ○ |
| | 4.4 | | ○ | ○ | | | ○ | ○ | | | ○ | ○ |
| | 2.2 | | | | ○ | ○ | ○ | ○ | | | | |
| | 1.25 | | | | | | | | ○ | ○ | ○ | ○ |
| Combined Resistance (kΩ) | | 12.00 | 4.40 | 3.22 | 2.20 | 1.86 | 1.47 | 1.31 | 1.25 | 1.13 | 0.97 | 0.90 |
| Overall Combined Resistance Ra = 10k, Rb = 7.5k | | 29.50 | 21.90 | 20.72 | 19.70 | 19.36 | 18.97 | 18.81 | 18.75 | 18.63 | 18.47 | 18.40 |
| Vct REF(L)[V] | | 0.90 | 1.43 | 1.57 | 1.71 | 1.77 | 1.84 | 1.86 | 1.88 | 1.90 | 1.93 | 1.94 |

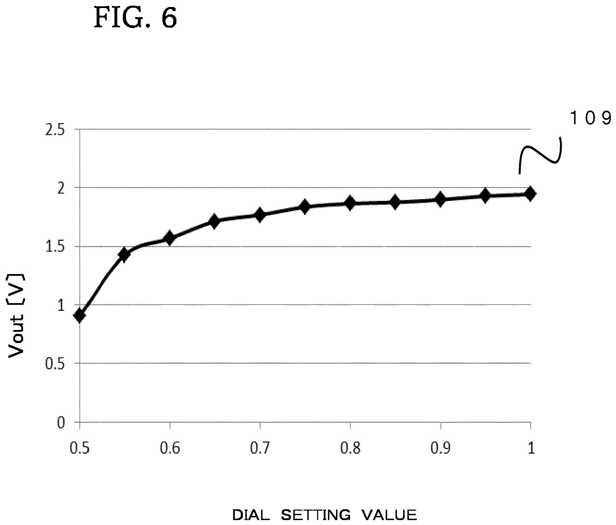

Selecting as in Table 7 means that rather than Vout increasing in proportion to the dial setting, as in a characteristic diagram of a relationship 109 between dial setting value and reference voltage shown in Fig. 6, the reference voltage can increase or decrease by being coordinated with a long time delay LTD pickup characteristic setting dial, whereby a Vout value that simulates a CT output having saturation characteristics, as in the case of the power supply CT 1, can be obtained.

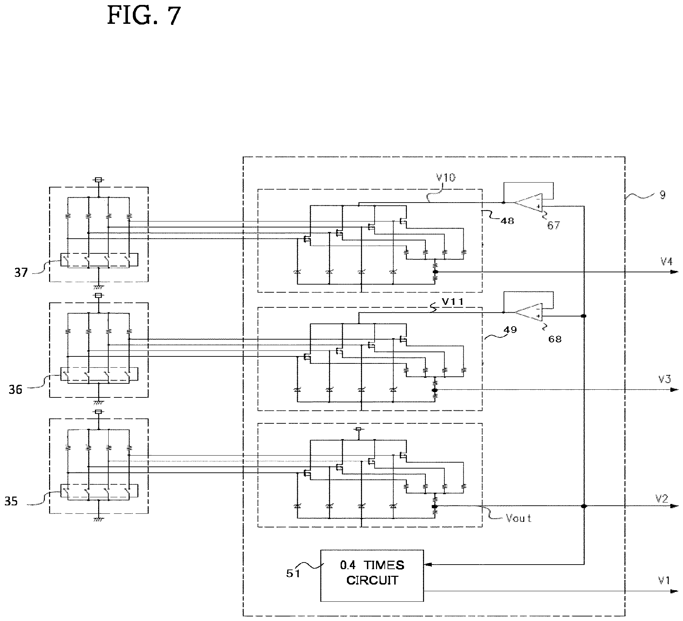

When a circuit wherein the switch 101 of Fig. 3 and the reference voltage converting circuit of Fig. 4 are connected via buffer circuits 67 and 68 is used as the reference voltage converting circuit 9, as shown in Fig. 7, a reference voltage in accordance with a setting position of a rated current In setting dial 35 formed of a rotary switch is output to V2, and by V2 being caused to pass through a 0.4 times circuit 51, a V1 signal can be output. Also, an instantaneous INST reference voltage generating circuit 48 and a short time delay STD reference voltage generating circuit 49 coordinated with an instantaneous INST pickup value setting dial 36 and a short time delay STD pickup value setting dial 37, formed of rotary switches, can output voltages V3 and V4 coordinated with a rated current setting of the rated current In setting dial 35, as voltages V10 and V11 applied to voltage dividing resistors are voltages of the same potential as V2.

According to the first embodiment of the invention, as heretofore described, a secondary side output level of the power supply CT is detected, and by the output level and an operation signal of the microcomputer being compared, tripping can be prevented even when a tripping signal is erroneously output from the microcomputer, and when the microcomputer does not start up, a microcomputer error can be displayed or the circuit breaker can be turned off, and it can be determined whether an operation of the microcomputer is normal or abnormal.

### Second Embodiment

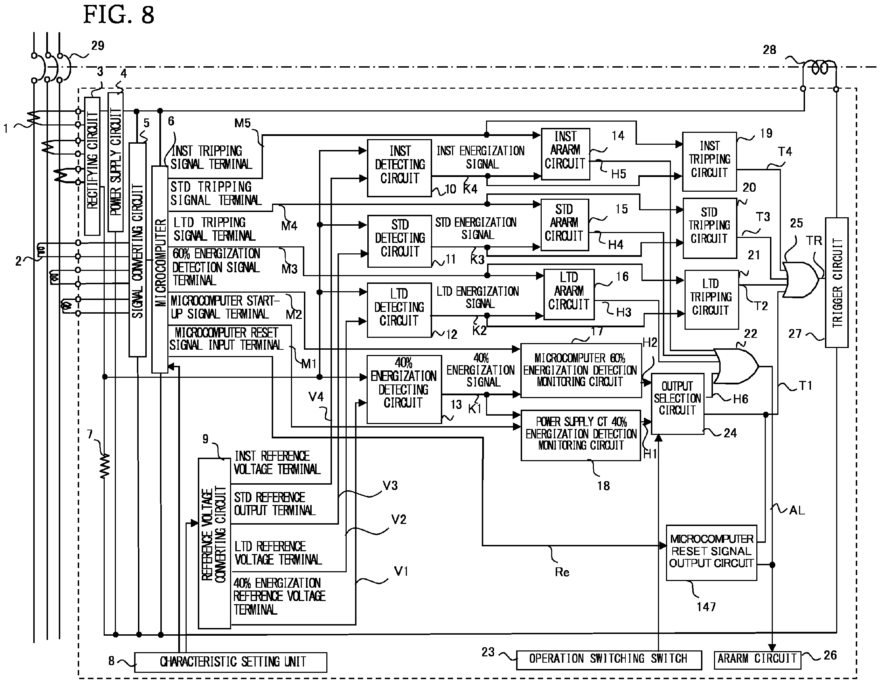

Fig. 8 is a circuit wherein a microcomputer reset signal output circuit 147 is added to the circuit having a duplicated function of detecting current shown in Fig. 1, and when there is an abnormality in the microcomputer 6 or the 40 % energization detecting circuit 13 and the signal T1 changes to the high state, or when the alarm signal AL from the OR circuit 22 changes to the high state, a signal Re to a microcomputer reset signal input terminal is changed to a high state, thereby causing the microcomputer 6 to be reset, and promoting recovery from the abnormal state.

According to the second embodiment of the invention, as heretofore described, there is an advantage in that recovery from an error display can be attempted by a microcomputer reset signal being transmitted when the microcomputer malfunctions.

### Third Embodiment

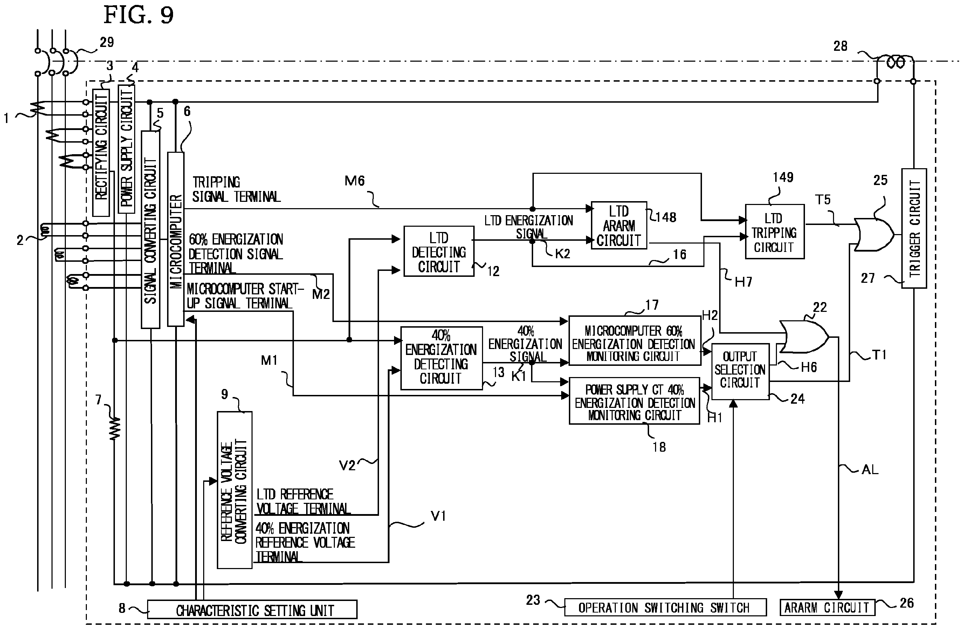

Fig. 9 is a circuit wherein individual evaluations of the long time delay LTD, short time delay STD, and instantaneous INST overcurrent regions are gathered in one, and the tripping signals M3 to M5 of the microcomputer 6 in Fig. 1 are integrated in the one signal M6. Also, the instantaneous INST alarm circuit 14, the short time delay STD alarm circuit 15, and the long time delay LTD alarm circuit 16 are integrated in an overcurrent alarm circuit 148, and the instantaneous INST tripping circuit 19, the short time delay STD tripping circuit 20, and the long time delay LTD tripping circuit 21 are integrated in an overcurrent tripping circuit 149.

In the same way as for the circuit of Fig. 1, a state of each signal depending on differences in the energization state of the main body is as in Table 8 and Table 9.

### [Table 8]

**Table 8**

| | | Normal Time | | | | | |
|---|---|---|---|---|---|---|---|
| Main Body Energization State | | 10 % | 40 % | 60 % | LTD Current | STD Current | INST Current |
| Microcomputer | M6 | L | L | L | H | H | H |
| Power supply CT detecting circuit | K2 | L | L | L | H | H | H |
| Microcomputer | M2 | L | L | H | H | H | H |
| Power supply CT detecting circuit | K1 | L | H | H | H | H | H |
| Microcomputer | M1 | H | H | H | H | H | H |
| Overcurrent alarm circuit | H7 | L | L | L | L | L | L |
| 60 % energization monitoring circuit | H2 | L | L | L | L | L | L |
| 40 % energization monitoring circuit | H1 | L | L | L | L | L | L |
| Overcurrent tripping circuit | T5 | L | L | L | H | H | H |
| Output selection circuit Tripping side selection | T1 | L | L | L | L | L | L |
| | H6 | | | | | | |
| Alarm circuit | AL | L | L | L | L | L | L |
| Tripping circuit | TR | L | L | L | H | H | H |

### [Table 9]

**Table 9**

| | | Normal Time | | | | | |
|---|---|---|---|---|---|---|---|
| Main Body Energization State | | 10 % | 40 % | 60 % | LTD Current | STD Current | INST Current |
| Microcomputer | M6 | L | L | L | H | H | H |
| Power supply CT detecting circuit | K2 | L | L | L | H | H | H |
| Microcomputer | M2 | L | L | H | H | H | H |
| Power supply CT detecting circuit | K1 | L | H | H | H | H | H |
| Microcomputer | M1 | H | H | H | H | H | H |
| Overcurrent alarm circuit | H7 | L | L | L | L | L | L |
| 60 % energization monitoring circuit | H2 | L | L | L | L | L | L |
| 40 % energization monitoring circuit | H1 | L | L | L | L | L | L |
| Overcurrent tripping circuit | T5 | L | L | L | H | H | H |
| Output selection circuit Tripping side selection | T1 | | | | | | |
| | H6 | L | L | L | L | L | L |
| Alarm circuit | AL | L | L | L | L | L | L |
| Tripping circuit | TR | L | L | L | H | H | H |

Table 8 is a table showing a state of each signal depending on differences in the energization state of the main body when the operation switching switch 23 in the third embodiment of the invention is set to the tripping side, and the overcurrent tripping device is normal.

Also, Table 9 is a table showing a state of each signal depending on differences in the energization state of the main body when the operation switching switch 23 in the third embodiment of the invention is set to the alarm side, and the overcurrent tripping device is normal. Assuming that the microcomputer starts up at 10 % of the rated current, the signal M1 changes to the high state when the main body is energized to 10 %, but the signal AL and the signal TR both remain in the low state, and neither an alarm output nor a turning off of the circuit breaker owing to excitation of the tripping coil 28 takes place.

In the same way, the signal M1 and the signal K1 change to the high state when the main body is energized to 40 %, but the signal AL and the signal TR both remain in the low state, and neither an alarm output nor a turning off of the circuit breaker owing to excitation of the tripping coil 28 takes place. The signal M1, the signal K1, and the signal M2 change to the high state when the main body is energized to 60 %, but the signal AL and the signal TR both remain in the low state, and neither an alarm output nor a turning off of the circuit breaker owing to excitation of the tripping coil 28 takes place. When an overcurrent in the long time delay LTD, the short time delay STD, or the instantaneous INST region flows, the signal M1, the signal K1, the signal M2, the signal K2, and the signal H6 change to the high state, the signal TR changes to the high state, and the circuit breaker is turned off by the tripping coil 28 being excited, but as the signal AL remains in the low state, no alarm output is carried out.

Next, a state of each signal depending on differences in the energization state of the main body when there is an abnormality in the microcomputer 6 or the 40 % energization detecting circuit 13 is shown in Table 10 and Table 11.

### [Table 10]

**Table 10**

| | | When Abnormality Occurs | | |
|---|---|---|---|---|
| Main Body Energization State | | 40 % | 60 % | 60 % |
| Microcomputer | M6 | L | L | H |
| Power supply CT detecting circuit | K2 | L | L | L |
| Microcomputer | M2 | L | H | H |
| Power supply CT detecting circuit | K1 | H | L | H |
| Microcomputer | M1 | L | H | H |
| Overcurrent alarm circuit | H7 | L | L | H |
| 60 % energization monitoring circuit | H2 | L | H | L |
| 40 % energization monitoring circuit | H1 | H | L | L |
| Overcurrent tripping circuit | T5 | L | L | L |
| Output selection circuit Tripping side selection | T1 | H | H | L |
| | H6 | | | |
| Alarm circuit | AL | L | L | H |
| Tripping circuit | TR | H | H | L |

### [Table 11]

**Table 11**

| | | When Abnormality Occurs | | |
|---|---|---|---|---|
| Main Body Energization State | | 40 % | 60 % | 60 % |
| Microcomputer | M6 | L | L | H |
| Power supply CT detecting circuit | K2 | L | L | L |
| Microcomputer | M2 | L | H | H |
| Power supply CT detecting circuit | K1 | H | L | H |
| Microcomputer | M1 | L | H | H |
| Overcurrent alarm circuit | H7 | L | L | H |
| 60 % energization monitoring circuit | H2 | L | H | L |
| 40 % energization monitoring circuit | H1 | H | L | L |
| Overcurrent tripping circuit | T5 | L | L | L |
| Output selection circuit Tripping side selection | T1 | | | |
| | H6 | H | H | L |
| Alarm circuit | AL | H | H | H |
| Tripping circuit | TR | L | L | L |

Table 10 is a table showing a state of each signal depending on differences in the energization state of the circuit breaker main body when the operation switching switch 23 in the third embodiment of the invention is set to the tripping side, and the overcurrent tripping device is abnormal.

Also, Table 11 is a table showing a state of each signal depending on differences in the energization state of the main body when the operation switching switch in the third embodiment of the invention is set to the alarm side, and the overcurrent tripping device is abnormal.

When the signal M1 remains in the low state due to an abnormality in the microcomputer 6, despite 40 % energization of the main body, the signal TR changes to the high state, the circuit breaker main body is turned off, and notification of the abnormality is carried out when the operation switching switch 23 of Table 10 is set to the tripping side, and when the operation switching switch 23 of Table 11 is set to the alarm side, the signal AL changes to the high state, and notification of the abnormality is carried out by an alarm being output.

Also, when the signal K1 remains in the low state due to an abnormality in the 40% energization detecting circuit 13, despite 60 % energization of the main body, the signal TR changes to the high state, the circuit breaker main body is turned off, and notification of the abnormality is carried out when the operation switching switch 23 of Table 10 is set to the tripping side, and when the operation switching switch 23 of Table 11 is set to the alarm side, the signal AL changes to the high state, and notification of the abnormality is carried out by an alarm being output.

In addition to this, when the signal M6 changes to the high state due to an abnormality in the microcomputer 6, despite 60 % energization of the main body, the signal AL changes to the high state, and notification of the abnormality is carried out by an alarm being output, both when the operation switching switch 23 of Table 10 is set to the tripping side and when the operation switching switch 23 is set to the alarm side of Table 11.

According to the third embodiment of the invention, as heretofore described, there is an advantage in that the circuit configuration can be simplified by the microcomputer tripping signal levels being integrated rather than divided.

The embodiments can be freely combined, and each embodiment can be modified or abbreviated as appropriate, without departing from the scope of the invention.

## Claims

1. A circuit breaker, comprising:
a first current detecting circuit that is adapted to detect a load current;
a second current detecting circuit that is adapted to detect the load current; and
comparison means that is adapted to compare an output signal of the first current detecting circuit and an output signal of the second current detecting circuit,
**characterized in that**
the first current detecting circuit is adapted to detect the load current using a microcomputer (6) in accordance with a signal output from a current detecting coil (2); and
the second current detecting circuit is adapted to detect the load current using an output current of a power supply CT (1);
wherein the output current of the power supply CT (1) of the second current detecting circuit is supplied to the microcomputer (6) of the first current detecting circuit as a drive power supply; and
wherein the circuit breaker is adapted to determine whether an operation of the microcomputer (6) is normal or abnormal based on an output of the comparison means.

2. The circuit breaker according to claim 1, wherein the microcomputer (6) is adapted to output a tripping signal after a set limit time when an overcurrent is detected, and to carry out an interruption only when the second current detecting circuit outputs an overcurrent determination signal.

3. The circuit breaker according to claim 2, wherein the microcomputer (6) is set so as to
output a long time delay LTD tripping signal (M3) after a first predetermined limit time in a case of a long time delay LTD region,
output the long time delay LTD tripping signal (M3) and a short time delay STD tripping signal (M4) after a second predetermined limit time in a case of a short time delay STD region, and
output the long time delay LTD tripping signal (M3), the short time delay STD tripping signal (M4), and an instantaneous INST tripping signal (M5) after a third predetermined limit time in a case of an instantaneous INST region,
in accordance with a magnitude of a detected current, and
when the microcomputer (6) outputs any one of the long time delay LTD tripping signal (M3), the short time delay STD tripping signal (M4), or the instantaneous INST tripping signal (M5) in a state in which it is not determined that a value of current detected by the second current detecting circuit is in the long time delay LTD region, an alarm is output.

4. The circuit breaker according to claim 2, wherein the microcomputer (6) is set so as to
output a long time delay LTD tripping signal (M3) after a first predetermined limit time in a case of a long time delay LTD region,
output the long time delay LTD tripping signal (M3) and a short time delay STD tripping signal (M4) after a second predetermined limit time in a case of a short time delay STD region, and
output the long time delay LTD tripping signal (M3), the short time delay STD tripping signal (M4), and an instantaneous INST tripping signal (M5) after a third predetermined limit time in a case of an instantaneous INST region,
in accordance with a magnitude of a detected current, and
when the microcomputer (6) outputs the instantaneous INST tripping signal (M5) in a state in which it is determined that a value of current detected by the second current detecting circuit is in the short time delay STD region, an alarm is output simultaneously with an interruption being carried out.

5. The circuit breaker according to claim 2, wherein the microcomputer (6) is set so as to
output a long time delay LTD tripping signal (M3) after a first predetermined limit time in a case of a long time delay LTD region,
output the long time delay LTD tripping signal (M3) and a short time delay STD tripping signal (M4) after a second predetermined limit time in a case of a short time delay STD region, and
output the long time delay LTD tripping signal (M3), the short time delay STD tripping signal (M4), and an instantaneous INST tripping signal (M5) after a third predetermined limit time in a case of an instantaneous INST region,
in accordance with a magnitude of a detected current, and
when the microcomputer (6) outputs the short time delay STD tripping signal (M4) or the instantaneous INST tripping signal (M5) in a state in which it is determined that a value of current detected by the second current detecting circuit is in the long time delay LTD region, an alarm is output simultaneously with an interruption being carried out.

6. The circuit breaker according to claim 2, comprising an operation switching switch (23) that is adapted to select an alarm output or an interruption operation when the second current detecting circuit detects a current such that the microcomputer (6) can be started up, but no start-up signal is output from the microcomputer (6).

7. The circuit breaker according to claim 2, comprising an operation switching switch (23) that is adapted to select an alarm output or an interruption operation when the microcomputer (6) detects energization by a current near a rated current, but the second current detecting circuit does not detect a current that is 40 % of the rated current.

8. The circuit breaker according to claim 2, wherein a reference voltage for the second current detecting circuit to determine an energizing current can increase or decrease in coordination with a long time delay LTD pickup characteristic setting dial, and the reference voltage can be of a value that takes saturation characteristics of the power supply CT (1) into consideration.

9. The circuit breaker according to claim 2, wherein a reference voltage for the second current detecting circuit to determine an energizing current can increase or decrease in coordination with a long time delay LTD pickup value setting dial, a short time delay STD pickup value setting dial (37), or an instantaneous INST pickup value setting dial (36), and the reference voltage can be of a value that takes saturation characteristics of the power supply CT (1) into consideration.

10. The circuit breaker according to claim 2, wherein, when the output signal of the first current detecting circuit and the output signal of the second current detecting circuit differ, recovery from an abnormal state can be carried out by the microcomputer (6) of the first current detecting circuit being reset.

## Patentansprüche

1. Schutzschalter, aufweisend:
eine erste Stromerfassungsschaltung, die zur Erfassung eines Laststroms ausgebildet ist;
eine zweite Stromerfassungsschaltung, die zur Erfassung des Laststroms ausgebildet ist; und
Vergleichsmittel, die dazu ausgebildet sind, ein Ausgangssignal der ersten Stromerfassungsschaltung und ein Ausgangssignal der zweiten Stromerfassungsschaltung zu vergleichen,
**dadurch gekennzeichnet, dass**
die erste Stromerfassungsschaltung dazu ausgebildet ist, den Laststrom unter Verwendung eines Mikrocomputers (6) in Übereinstimmung mit einem von einer Stromerfassungsspule (2) ausgegebenen Signal zu erfassen; und
die zweite Stromerfassungsschaltung dazu ausgebildet, den Laststrom unter Verwendung eines Ausgangsstroms eines Stromversorgungs-Stromwandlers (Stromversorgungs-CTs) (1) zu erfassen;
wobei der Ausgangsstrom des Stromversorgungs-Stromwandlers (1) der zweiten Stromerfassungsschaltung dem Mikrocomputer (6) der ersten Stromerfassungsschaltung als eine Treiberstromversorgung zugeführt wird; und
wobei der Schutzschalter dazu ausgebildet ist, basierend auf einer Ausgabe des Vergleichsmittels zu bestimmen, ob ein Betrieb des Mikrocomputers (6) normal oder anomal ist.

2. Schutzschalter nach Anspruch 1, wobei der Mikrocomputer (6) dazu ausgebildet ist, nach einer vorgegebenen Grenzzeit ein Auslösesignal auszugeben, wenn ein Überstrom erfasst wird, und eine Unterbrechung nur dann auszuführen, wenn auch die zweite Stromerfassungsschaltung ein Überstrombestimmungssignal ausgibt.

3. Schutzschalter nach Anspruch 2, wobei der Mikrocomputer (6) dazu ausgebildet ist, in Übereinstimmung mit einer Größe eines erfassten Stroms
im Falle eines Langzeit-verzögerten LTD-Bereichs nach einer ersten vorgegebenen Grenzzeit ein Langzeit-verzögertes LTD-Auslösesignal (M3) auszugeben,
im Falle eines Kurzzeit-verzögerten STD-Bereichs nach einer zweiten vorbestimmten Grenzzeit das Langzeit-verzögerte LTD-Auslösesignal (M3) und ein Kurzzeit-verzögertes STD-Auslösesignal (M4) auszugeben, und nach einer dritten vorbestimmten Grenzzeit im Falle eines unverzögerten INST-Bereichs das Langzeit-verzögerte LTD-Auslösesignal (M3), das Kurzzeit-verzögerte STD-Auslösesignal (M4) und ein unverzögertes INST-Auslösesignal (M5) auszugeben,
und
wenn der Mikrocomputer (6) eines von dem Langzeit-verzögerten LTD-Auslösesignal (M3), dem Kurzzeit-verzögerten STD-Auslösesignal (M4) oder dem unverzögerten INST-Auslösesignal (M5) in einem Zustand ausgibt, in dem nicht festgestellt wird, dass ein von der zweiten Stromerfassungsschaltung erfasster Stromwert im Langzeit-verzögerten LTD-Bereich liegt, ein Alarm ausgegeben wird.

4. Schutzschalter nach Anspruch 2, wobei der Mikrocomputer (6) dazu ausgebildet ist, in Übereinstimmung mit einer Größe eines erfassten Stroms
im Falle eines Langzeit-verzögerten LTD-Bereichs nach einer ersten vorgegebenen Grenzzeit ein langzeit-verzögertes LTD-Auslösesignal (M3) auszugeben,
im Falle eines Kurzzeit-verzögerten STD-Bereichs nach einer zweiten vorbestimmten Grenzzeit das langzeit-verzögerte LTD-Auslösesignal (M3) und ein kurzzeit-verzögertes STD-Auslösesignal (M4) auszugeben, und nach einer dritten vorbestimmten Grenzzeit im Falle eines unverzögerten INST-Bereichs das langzeit-verzögerte LTD-Auslösesignal (M3), das kurzzeit-verzögerte STD-Auslösesignal (M4) und ein unverzögertes INST-Auslösesignal (M5) auszugeben,
und
wenn der Mikrocomputer (6) das unverzögerte INST-Auslösesignal (M5) in einem Zustand ausgibt, in dem festgestellt wird, dass ein von der zweiten Stromerfassungsschaltung erfasster Stromwert im Kurzzeit-verzögerten STD-Bereich liegt, gleichzeitig mit der Ausführung einer Unterbrechung ein Alarm ausgegeben wird.

5. Schutzschalter nach Anspruch 2, wobei der Mikrocomputer (6) dazu ausgebildet ist, in Übereinstimmung mit einer Größe eines erfassten Stroms
im Falle eines Langzeit-verzögerten LTD-Bereichs nach einer ersten vorgegebenen Grenzzeit ein langzeit-verzögertes LTD-Auslösesignal (M3) auszugeben,
im Falle eines Kurzzeit-verzögerten STD-Bereichs nach einer zweiten vorbestimmten Grenzzeit das langzeit-verzögerte LTD-Auslösesignal (M3) und ein kurzzeit-verzögertes STD-Auslösesignal (M4) auszugeben, und nach einer dritten vorbestimmten Grenzzeit im Falle eines unverzögerten INST-Bereichs das langzeit-verzögerte LTD-Auslösesignal (M3), das kurzzeit-verzögerte STD-Auslösesignal (M4) und ein unverzögertes INST-Auslösesignal (M5) auszugeben,
und
wenn der Mikrocomputer (6) das kurzzeit-verzögerte STD-Auslösesignal (M4) oder das unverzögerte INST-Auslösesignal (M5) in einem Zustand ausgibt, in dem festgestellt wird, dass ein von der zweiten Stromerfassungsschaltung erfasster Stromwert im Langzeit-verzögerten LTD-Bereich liegt, gleichzeitig mit der Ausführung einer Unterbrechung ein Alarm ausgegeben wird.

6. Schutzschalter nach Anspruch 2, aufweisend einen Bedienungsschalter (23), der dazu ausgebildet ist, eine Alarmausgabe oder eine Unterbrechungsbetätigung auszuwählen, wenn die zweite Stromerfassungsschaltung einen Strom erfasst, der es erlaubt, dass der Mikrocomputer (6) gestartet werden kann, aber kein Startsignal vom Mikrocomputer (6) ausgegeben wird.

7. Schutzschalter nach Anspruch 2, aufweisend einen Bedienungsschalter (23), der dazu ausgebildet ist, eine Alarmausgabe oder eine Unterbrechungsbetätigung auszuwählen, wenn der Mikrocomputer (6) eine Erregung durch einen Strom in der Nähe eines Nennstroms feststellt, aber die zweite Stromerfassungsschaltung keinen Strom erfasst, der 40 % des Nennstroms beträgt.

8. Schutzschalter nach Anspruch 2, wobei eine Referenzspannung für die zweite Stromerfassungsschaltung zum Bestimmen eines Erregerstroms in Abhängigkeit von einem Einstellrad für die langzeit-verzögerte LTD-Ansprechcharakteristik ansteigen oder abfallen kann, und die Referenzspannung einen Wert haben kann, der die Sättigungscharakteristik des Stromversorgungs-Stromwandlers (1) berücksichtigt.

9. Schutzschalter nach Anspruch 2, wobei eine Referenzspannung für die zweite Stromerfassungsschaltung zum Bestimmen eines Erregerstroms in Abhängigkeit von einem Einstellrad für einen Langzeit-verzögerten LTD-Ansprechwert, einem Einstellrad (37) für einen Kurzzeit-verzögerten STD-Ansprechwert oder einem Einstellrad (36) für einen unverzögerten INST-Ansprechwert ansteigen oder abfallen kann, und die Referenzspannung einen Wert haben kann, der die Sättigungscharakteristik des Stromversorgungs-Stromwandlers (1) berücksichtigt.

10. Schutzschalter nach Anspruch 2, wobei, wenn sich das Ausgangssignal der ersten Stromerfassungsschaltung und das Ausgangssignal der zweiten Stromerfassungsschaltung unterscheiden, die Wiederherstellung aus einem anomalen Zustand dadurch durchgeführt werden kann, dass der Mikrocomputer (6) der ersten Stromerfassungsschaltung zurückgesetzt wird.

## Revendications

1. Disjoncteur, comprenant :
un premier circuit de détection de courant qui est adapté pour détecter un courant de charge ;
un second circuit de détection de courant qui est adapté pour détecter le courant de charge ; et
un moyen de comparaison qui est adapté pour comparer un signal de sortie du premier circuit de détection de courant et un signal de sortie du second circuit de détection de courant,
**caractérisé en ce que**
le premier circuit de détection de courant est adapté pour détecter le courant de charge à l'aide d'un micro-ordinateur (6) en conformité avec un signal fourni en sortie depuis une bobine de détection de courant (2) ; et
le second circuit de détection de courant est adapté pour détecter le courant de charge à l'aide d'un courant de sortie d'une alimentation électrique CT (1) ;
dans lequel le courant de sortie de l'alimentation électrique CT (1) du second circuit de détection de courant est fourni au micro-ordinateur (6) du premier circuit de détection de courant sous la forme d'une alimentation électrique de pilotage ; et
dans lequel le disjoncteur est adapté pour déterminer si un fonctionnement du micro-ordinateur (6) est normal ou anormal sur la base d'une sortie du moyen de comparaison.

2. Disjoncteur selon la revendication 1, dans lequel le micro-ordinateur (6) est adapté pour fournir en sortie un signal de déclenchement après une durée limite réglée lorsqu'une surintensité est détectée, et pour réaliser une interruption uniquement lorsque le second circuit de détection de courant fournit en sortie un signal de détermination de surintensité.

3. Disjoncteur selon la revendication 2, dans lequel le micro-ordinateur (6) est réglé de façon à
fournir en sortie un signal de déclenchement de retard longue durée LTD (M3) après une première durée limite prédéterminée dans un cas d'une région de retard longue durée LTD,
fournir en sortie le signal de déclenchement de retard longue durée LTD (M3) et un signal de déclenchement de retard courte durée STD (M4) après une deuxième durée limite prédéterminée dans un cas d'une région de retard courte durée STD, et
fournir en sortie le signal de déclenchement de retard longue durée LTD (M3), le signal de déclenchement de retard courte durée STD (M4), et un signal de déclenchement instantané INST (M5) après une troisième durée limite prédéterminée dans un cas d'une région instantanée INST,
selon une grandeur d'un courant détecté, et
lorsque le micro-ordinateur (6) fournit en sortie l'un quelconque parmi le signal de déclenchement de retard longue durée LTD (M3), le signal de déclenchement de retard courte durée STD (M4), ou le signal de déclenchement instantané INST (M5) dans un état dans lequel il n'est pas déterminé qu'une valeur de courant détecté par le second circuit de détection de courant se trouve dans la région de retard longue durée LTD, une alarme est envoyée en sortie.

4. Disjoncteur selon la revendication 2, dans lequel le micro-ordinateur (6) est réglé de façon à
fournir en sortie un signal de déclenchement de retard longue durée LTD (M3) après une première durée limite prédéterminée dans un cas d'une région de retard longue durée LTD,
fournir en sortie le signal de déclenchement de retard longue durée LTD (M3) et un signal de déclenchement de retard courte durée STD (M4) après une deuxième durée limite prédéterminée dans un cas d'une région de retard courte durée STD, et
fournir en sortie le signal de déclenchement de retard longue durée LTD (M3), le signal de déclenchement de retard courte durée STD (M4), et un signal de déclenchement instantané INST (M5) après une troisième durée limite prédéterminée dans un cas d'une région instantanée INST,
selon une grandeur d'un courant détecté, et
lorsque le micro-ordinateur (6) fournit en sortie le signal de déclenchement instantané INST (M5) dans un état dans lequel il est déterminé qu'une valeur de courant détecté par le second circuit de détection de courant se trouve dans la région de retard courte durée STD, une alarme est envoyée en sortie simultanément à la réalisation d'une interruption.

5. Disjoncteur selon la revendication 2, dans lequel le micro-ordinateur (6) est réglé de façon à
fournir en sortie un signal de déclenchement de retard longue durée LTD (M3) après une première durée limite prédéterminée dans un cas d'une région de retard longue durée LTD,
fournir en sortie le signal de déclenchement de retard longue durée LTD (M3) et un signal de déclenchement de retard courte durée STD (M4) après une deuxième durée limite prédéterminée dans un cas d'une région de retard courte durée STD, et
fournir en sortie le signal de déclenchement de retard longue durée LTD (M3), le signal de déclenchement de retard courte durée STD (M4), et un signal de déclenchement instantané INST (M5) après une troisième durée limite prédéterminée dans un cas d'une région instantanée INST,
selon une grandeur d'un courant détecté, et
lorsque le micro-ordinateur (6) fournit en sortie le signal de déclenchement de retard courte durée STD (M4) ou le signal de déclenchement instantané INST (M5) dans un état dans lequel il est déterminé qu'une valeur de courant détecté par le second circuit de détection de courant se trouve dans la région de retard longue durée LTD, une alarme est envoyée en sortie simultanément à la réalisation d'une interruption.

6. Disjoncteur selon la revendication 2, comprenant un commutateur de commutation d'opération (23) qui est adapté pour sélectionner une sortie d'alarme ou une opération d'interruption lorsque le second circuit de détection de courant détecte un courant de sorte que le micro-ordinateur (6) puisse être démarré, mais aucun signal de démarrage n'est envoyé en sortie depuis le micro-ordinateur (6).

7. Disjoncteur selon la revendication 2, comprenant un commutateur de commutation d'opération (23) qui est adapté pour sélectionner une sortie d'alarme ou une opération d'interruption lorsque le micro-ordinateur (6) détecte une mise sous tension par un courant proche d'un courant nominal, mais le second circuit de détection de courant ne détecte pas un courant qui est de 40 % du courant nominal.

8. Disjoncteur selon la revendication 2, dans lequel une tension de référence pour le second circuit de détection de courant afin de déterminer un courant de mise sous tension peut augmenter ou diminuer en coordination avec un cadran de réglage de caractéristique d'excitation de retard longue durée LTD, et la tension de référence peut être une valeur qui tient compte de caractéristiques de saturation de l'alimentation électrique CT (1).

9. Disjoncteur selon la revendication 2, dans lequel une tension de référence pour le second circuit de détection de courant afin de déterminer un courant de mise sous tension peut augmenter ou diminuer en coordination avec un cadran de réglage de valeur d'excitation de retard longue durée LTD, un cadran de réglage de valeur d'excitation de retard courte durée STD (37), ou un cadran de réglage de valeur d'excitation instantanée INST (36), et la tension de référence peut être une valeur qui tient compte de caractéristiques de saturation de l'alimentation électrique CT (1).

10. Disjoncteur selon la revendication 2, dans lequel, lorsque le signal de sortie du premier circuit de détection de courant et le signal de sortie du second circuit de détection de courant diffèrent, une récupération à partir d'un état anormal peut être réalisée par une réinitialisation du micro-ordinateur (6) du premier circuit de détection de courant.
